# EUROPEAN PATENT APPLICATION

(11) **EP 4 414 784 A1**
(43) Date of publication of application: **14.08.2024**
(21) Application number: 23155978.2
(22) Date of filing: 10.02.2023
(51) Int. Cl.: G03F 7/00

(54) **FLUID NOZZLE FOR A PATTERNING DEVICE ENVIRONMENT OF A LITHOGRAPHIC APPARATUS**

(71) Applicant: ASML Netherlands B.V., 5500 AH Veldhoven (NL)
(72) Inventor: VAN DEN AKKER, Emericus, Antoon, Theodorus, 5500 AH Veldhoven (NL); HAZARI, Syed, Aaquib, 5500 AH Veldhoven (NL); HUANG, Zhuangxiong, 5500 AH Veldhoven (NL); DEMIRKESEN, Cem, 5500 AH Veldhoven (NL)
(74) Representative: ASML Netherlands B.V.

(57) **Abstract**

A fluid nozzle for a patterning device environment of a lithographic apparatus comprising an elongate structure having an upper surface and a lower surface, at least one lower opening provided in the lower surface of the elongate structure, and a conduit connected to the at least one lower opening, the at least one lower opening being configured to provide a flow of fluid delivered via the conduit.

## Description

### FIELD

The present invention relates to a fluid nozzle for a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a deep ultraviolet (DUV) wavelength of 193 nm.

Contamination within lithographic apparatus may have a negative impact upon the accuracy with which a pattern is projected from a patterning device onto a substrate. For this reason it may be desirable to periodically clean an environment within which the patterning device is located. In this document such an environment may be referred to as a patterning device environment. Cleaning of the patterning device environment may for example be performed when a patterning device is not present within the patterning device environment (the patterning device is removable and may be periodically removed for cleaning or may be swapped for a different patterning device bearing a different pattern).

Cleaning of the patterning device environment may for example comprise directing gas towards surfaces within the patterning device environment which are to be cleaned. However, in existing lithographic apparatus the effectiveness of this cleaning may be limited.

It may be desirable to provide a fluid nozzle that overcomes or mitigates one or more problems associated with the prior art.

### SUMMARY

According to a first aspect of the present invention, there is provided a fluid nozzle for a patterning device environment of a lithographic apparatus comprising an elongate structure having an upper surface and a lower surface, at least one lower opening provided in the lower surface of the elongate structure, and a conduit connected to the at least one lower opening, the at least one lower opening being configured to provide a flow of fluid delivered via the conduit.

Advantageously the fluid nozzle provides effective cleaning of a lithographic patterning device environment. The fluid nozzle may provide effective cleaning of a masking blade.

According to a second aspect of the present invention, there is provided a fluid nozzle for a patterning device environment of a lithographic apparatus comprising an elongate structure having an upper surface and a lower surface, at least one upper opening provided in the upper surface of the elongate structure, and a conduit connected to the at least one upper opening, the at least one upper opening being configured to provide a flow of fluid delivered via the conduit.

Advantageously the fluid nozzle provides effective cleaning of a lithographic patterning device environment. The fluid nozzle may provide effective cleaning of a patterning device support structure.

According to a third aspect of the present invention, there is provided a fluid nozzle for a patterning device environment of a lithographic apparatus comprising an elongate structure having an upper surface and a lower surface, at least one upper opening provided in the upper surface of the elongate structure and at least one lower opening provided in the lower surface of the elongate structure, and a conduit connected to the at least one upper opening and the at least one lower opening, the at least one upper opening and the at least one lower opening being configured to provide a flow of fluid delivered via the conduit.

The at least one lower opening and/or the at least one upper opening may be configured to provide a jet of fluid.

The at least one lower opening and/or the at least one upper opening may comprise a series of openings which extend across the elongate structure.

The least one lower opening and/or the at least one upper opening may be provided adjacent to an edge which forms part of the elongate structure.

A portion of the conduit may extend above the at least one lower opening. The conduit portion may be wider than the at least one lower opening.

An area of the lower openings may be smaller than an area of the upper openings.

The least one upper opening and/or the at least one lower opening may have a width of up to 4mm.

The at least one lower opening may be oriented at an angle of between 20° and 70° relative to a plane which is perpendicular to the elongate structure.

The at least one upper opening may be oriented at an angle of between 20° and 70° relative to a plane which is perpendicular to the elongate structure.

The fluid nozzle may further comprise an opening provided in an end wall of the elongate structure.

The elongate structure may comprise a main body portion and an additional portion. The at least one lower opening may be provided in the lower surface of the main body portion and/or the additional portion. The at least one upper opening may be provided in the upper surface of the main body portion and/or the additional portion.

According to a fourth aspect of the invention, there is provided a lithographic patterning device environment comprising a fluid nozzle according to any preceding aspect of the invention, wherein the at least one lower opening provided in the lower surface of the elongate structure is located above a masking blade.

According to a fifth aspect of the invention, there is provided a lithographic apparatus comprising the lithographic patterning device environment of the fourth aspect of the invention, and further comprising a fluid supply configured to supply fluid to the at least one lower opening at a flow rate which provides a shear stress of 50 Pa or more at the masking blade.

According to a sixth aspect of the invention, there is provided a lithographic patterning device environment comprising a fluid nozzle according to any preceding aspect of the invention, wherein the at least one upper opening provided in the upper surface of the elongate structure is located below a patterning device support structure. a masking blade.

According to a seventh aspect of the invention, there is provided a lithographic apparatus comprising the lithographic patterning device environment of the sixth aspect of the invention, and further comprising a fluid supply configured to supply fluid to the at least one lower opening at a flow rate which provides a shear stress of 50 Pa or more at the patterning device support structure.

The fluid supply may be configured to supply air.

According to an eighth aspect of the invention, there is provided a method of cleaning a patterning device environment of a lithographic apparatus, the method comprising providing fluid to a fluid nozzle elongate structure, and directing the fluid out of at least one lower opening provided in a lower surface of the elongate structure, such that the fluid is incident upon a masking blade of the patterning device environment at a flow rate which is sufficiently high that contamination particles are removed from the masking blades.

According to a ninth aspect of the invention, there is provided a method of cleaning a patterning device environment of a lithographic apparatus, the method comprising providing fluid to a fluid nozzle elongate structure, and directing the fluid out of at least one upper opening provided in an upper surface of the elongate structure, such that the fluid is incident upon a cleaning reticle or support structure in the patterning device environment at a flow rate which is sufficiently high that contamination particles are removed from the cleaning reticle or the support structure.

The fluid may be directed at an angle of between 20° and 70° relative to a vertical plane.

The fluid may be air.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system which includes a fluid nozzle according to an embodiment of the invention;
- Figure 2 schematically depicts in side cross-section a patterning device environment of the lithographic system, including the fluid nozzle;
- Figure 3 schematically depicts the fluid nozzle in more detail;
- Figure 4 schematically depicts a distal end of the fluid nozzle in more detail; and
- Figure 5 schematically depicts in cross-section the fluid nozzle viewed from above.

### DETAILED DESCRIPTION

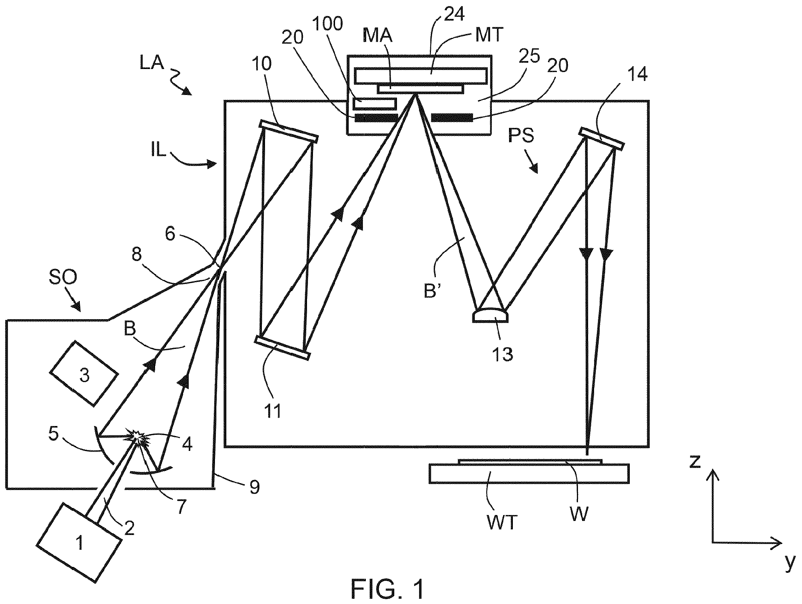

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The patterning device MA and other elements may be provided within a housing 24. An interior defined by the housing may be referred to as a patterning device environment 25. The housing 24 may be substantially closed, apart from an opening at a bottom end of the housing. Masking blades 20a,b are provided in the patterning device environment 25. The masking blades 20a,b are used to selectively mask areas of the patterning device MA, such that only a desired portion of the patterning device receives EUV radiation at any given time.

During a scanning exposure, the patterning device MA and support structure MT move in the y-direction, and the substrate W and substrate table WT move in the opposite y-direction (and vice-versa). In this way, a band of EUV radiation passes over the patterning device MA and passes over an exposure field on the substrate W.

A fluid nozzle 100 according to an embodiment of the invention is provided in the patterning device environment 25. The fluid nozzle 100 is located between one of the masking blades 20a and the patterning device MA plus support structure MT. During cleaning of the patterning device environment 25, the patterning device MA may be absent from the patterning device environment, in which case the fluid nozzle 100 is located between the masking blade 20a and the support structure MT. The fluid nozzle 100 is described in detail further below.

A relative vacuum, i.e. a small amount of gas (e.g. hydrogen) at a pressure well below atmospheric pressure, may be provided in the radiation source SO, in the illumination system IL, and/or in the projection system PS. The same is also the case for the patterning device environment 25. That is, gas at a pressure below atmospheric pressure is present in the patterning device environment 25. The gas may for example be hydrogen.

The radiation source SO shown in Figure 1 is, for example, of a type which may be referred to as a laser produced plasma (LPP) source. A laser system 1, which may, for example, include a COz laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

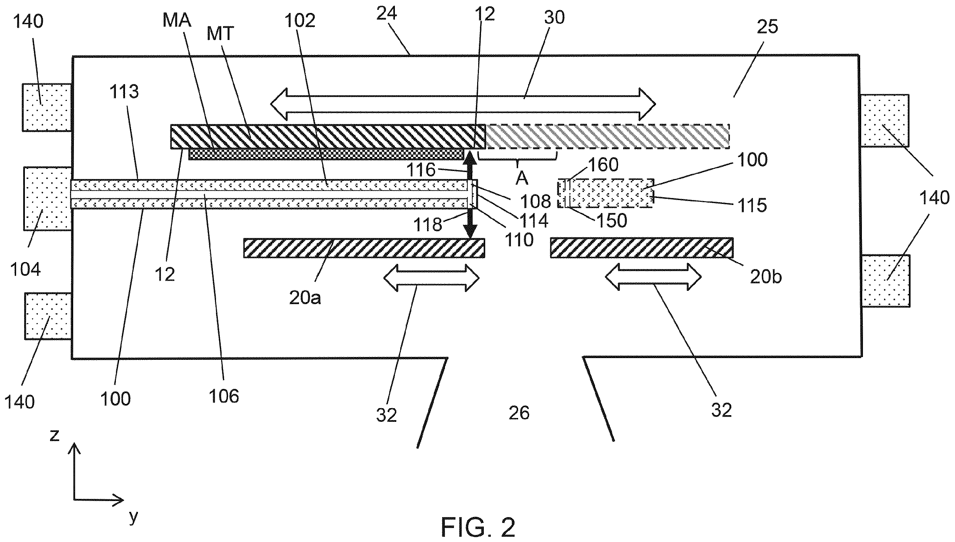

Figure 2 schematically depicts part of the lithographic apparatus LA in more detail. Specifically, Figure 2 schematically depicts the housing 24 of the patterning device environment 25, the support structure MT, the patterning device MA, the masking blades 20a,b, the fluid nozzle 100, a fluid supply 104, and fluid extraction systems 140.

The support structure MT (with the patterning device MA) is moveable in a scanning direction of the lithographic apparatus (which may be referred to as the Y-direction), as schematically indicated by a double headed arrow 30. The support structure MT is depicted at opposite ends of its range of motion in the Y-direction. That is, on the left hand side of Figure 2 the support structure MT is shown in its furthest left-hand position. On the right hand side of Figure 2, the support structure MT is shown at its furthest right-hand position (using a dashed outline and greyed shading, and without the patterning device MA being present for ease of illustration).

An opening 26 is provided at a lowermost end of the housing 24. During lithographic exposures, EUV radiation enters the housing 24 through the opening 26, is reflected from the patterning device MA and then exits through the same opening.

The fluid nozzle 100 comprises an elongate structure 102. In the depicted embodiment the fluid nozzle 100 extends from a wall of the housing 24. However the fluid nozzle may have a different arrangement.

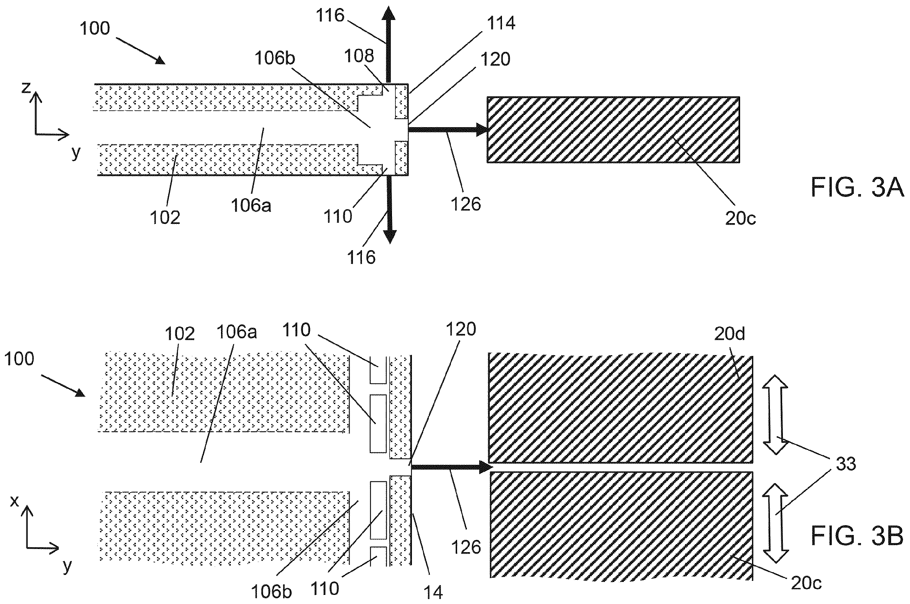

A fluid supply 104 is connected to the fluid nozzle 100, e.g. through the wall of the housing 24. The fluid supply may comprise a valve which is connected via a conduit to a tank of fluid (not depicted). The fluid nozzle 100 further comprises a conduit 106 which extends from the fluid supply 104 to openings 108, 110 provided in the elongate structure 102. A series of openings 108 is provided on an upper surface of the fluid nozzle 100, and a series of openings 110 is provided on a lower surface of the fluid nozzle. The series of openings 108, 110 extend perpendicular to the scanning direction (i.e. extend in the X-direction), as explained below in connection with Figures 3-5. The series of openings 108, 100 extend across the elongate structure 102. The series of openings 108, 110 may be provided adjacent to an edge 114 which forms part of the elongate structure.

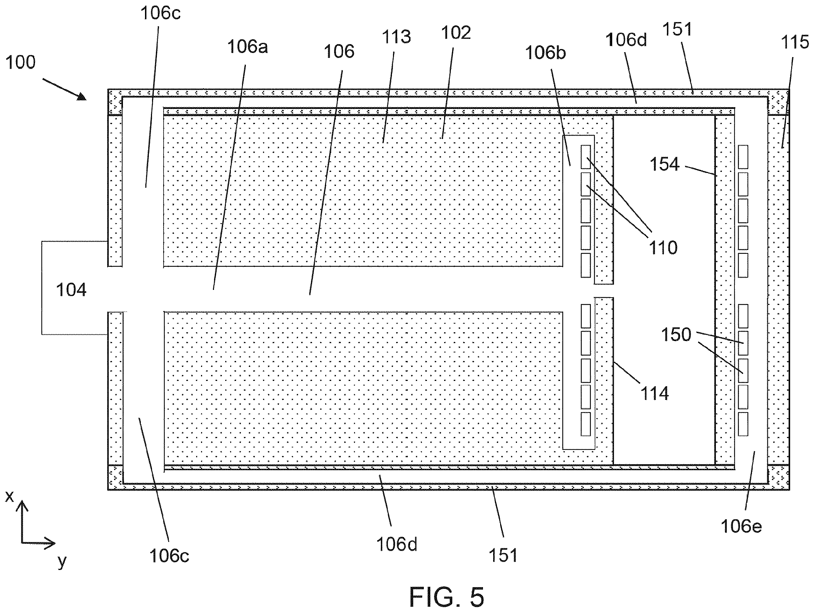

In an embodiment, the fluid nozzle 100 may further comprise an additional portion 115 which is located on an opposite side of an exposure slit area A that is illuminated by EUV radiation during lithographic exposures. Thus, the fluid nozzle may comprise a main body portion 113 and an additional portion 115. Features of this embodiment are described further below in connection with Figure 5. Openings 150, 160 may be provided in the additional portion. The openings 150, 160 in the additional portion may have the same properties as openings described herein in connection with the main body portion 113. The openings 150, 160 in the additional portion 115 may be provided in addition to, or instead of, openings in the main body portion 113. In other embodiments, the additional portion 115 may be omitted. In other embodiments, the additional portion 115 may be present but may have no openings. In other embodiments, the additional portion 115 may have openings but these may have different properties from the openings provided in the main body portion.

The fluid extraction systems 140 may comprise in inlets connected to one or more pumps (not depicted). The fluid extraction systems 140 are configured to remove fluid (e.g. gas) from the patterning device environment 25, and thereby remove contamination which is being carried by the fluid. Four fluid extraction systems are depicted in Figure 2. However, this is merely schematic, and any number of fluid extraction systems may be provided. The fluid extraction systems 140 may be distributed around the patterning device environment 25.

In use, a cleaning process may be performed when lithographic exposure of a substrate is not taking place. The cleaning process described herein is with reference to fluid provided from the main body portion 113. However, the cleaning process may additionally or alternatively provide fluid from the additional body portion 115 (if the additional body portion is present). The cleaning process may be referred to as a flushing operation. Prior to performing the cleaning process, a patterning device MA which has been used for lithographic exposures may be removed from the patterning device environment 25. A cleaning patterning device MA, which may be referred to as a cleaning reticle, may be loaded onto the support structure MT. The cleaning reticle MA may be analysed after cleaning has taken place to see how much contamination is on the cleaning reticle. This will provide an indication of how clean the patterning device environment 25 is. Analysis of the cleaning reticle MA may comprise removing the cleaning reticle from the lithographic apparatus LA and using a tool to look for contamination on the cleaning reticle. The cleaning reticle MA would not usually be used during lithographic exposures.

In the cleaning process, a jet of fluid 116 is delivered out of the upper openings 108 and upwards towards the support structure MT and the cleaning reticle MA. The fluid may for example be air, or another gas. The fluid may be air that has been cleaned to minimise contamination of the air (e.g. also to remove water from the air). The following description refers to air. However, other fluid may be ued instead of air. This also applies to fluid 118 delivered out of the lower openings 110.

The jet of air 116 is provided as a band of air which extends in the X-direction (i.e. orthogonal to the scanning direction). The orientation of the openings 108 will determine the orientation of the jet of air 116 (the jet of air may have the same orientation as the openings). The jet of air 116 may be substantially vertical (as illustrated), i.e. extend in the Z-direction. Alternatively, the jet of air 116 may subtend an angle of less than 90° relative to the Z-direction such that the jet of air has a component in the Y-direction (or -Y-direction). This is advantageous because it may provide flow of air in a preferred direction. For example, the jet of air 116 may be angled such that it points at least partially away from the edge 114 of the main body 113. The jet of air 116 may subtend an angle of 45° relative to the -Y-direction. The jet of air 116 may subtend an angle of between 20° and 70° relative to the -Y-direction. This may advantageously direct contamination particles towards one or more fluid extraction systems 140.

Alternatively, For example, the jet of air 116 may be angled such that it points at least partially towards the edge 114 of the main body 113. The jet of air 116 may subtend an angle of 45° relative to the Y-direction. The jet of air 116 may subtend an angle of between 20° and 70° relative to the Y-direction. This may also advantageously direct contamination particles towards one or more fluid extraction systems 140. However, the angled jet of air 116 pointing towards the edge 114 of the main body 113 may be less preferred compared with the angled jet of air 116 pointing away from the edge of the main body (i.e. in the -Y-direction). This is because the angled jet of air 116 pointing away from the edge of the main body is more effective at moving contamination particles away from a surface which will be adjacent to a patterning device MA during lithographic exposures.

In general, the jet of air 116 may be angled at between 20° and 70° relative to a plane which is perpendicular to the elongate structure 102.

During the cleaning process, a jet of fluid 118 is delivered out of the openings 110 on the lower surface of the fluid nozzle 100. The jet of fluid 118 is directed downwards towards the left hand masking blade 20a. In this embodiment the fluid is the same fluid as delivered out of the upper openings 108, and may be air. The masking blades 20a,b are moveable in the Y-direction, and may be moved such that the jet of fluid 118 is directed towards both masking blades at different times.

The openings 110 on the lower surface of the fluid nozzle 100 determine the orientation of the jet of air 118. The jet of air 118 may be substantially vertical (as illustrated), i.e. extend downwards in the Z-direction. Alternatively, the jet of air 118 may subtend an angle of less than 90° relative to the downwards Z-direction such that the jet of air has a component in the Y-direction (or -Y-direction). This is advantageous because it may provide flow of air that directs contamination particles towards a fluid extraction system 140. The jet of air 118 may subtend an angle of 45° relative to the Y-direction (or the -Y-direction). The jet of air 118 may subtend an angle of between 20° and 70° relative to the Y-direction (or the -Y-direction).

In general, the jet of air 118 may be angled at between 20° and 70° relative to a plane which is perpendicular to the elongate structure 102.

In some embodiments, openings 110 may be provided on the lower surface of the fluid nozzle 100, without openings also being provided on the upper surface of the fluid nozzle. Where this is the case, cleaning of the masking blades 20a,b is provided. There may be less cleaning or no cleaning of the cleaning reticle and surrounding area.

Figure 3 schematically depicts in cross-section and with more detail part of the fluid nozzle 100 together with two masking blades 20c,d. Figure 3A depicts the fluid nozzle 100 and one of the masking blades 20c viewed from one side. Figure 3B depicts the fluid nozzle 100 and the two masking blades 20c,d viewed from above.

The fluid nozzle 100 includes an opening 120 at an end of the fluid nozzle which faces towards the masking blades 20c,d. This opening 120 may be referred to as an end opening because it is formed in an edge 114 of the fluid nozzle 100. The masking blades 20c,d are moveable in the X-direction as depicted by arrows 33. The masking blades 20c,d are provided at a vertical position (Z-direction position) which corresponds with the vertical position of the fluid nozzle 100. The masking blades 20c,d may be used during lithographic exposures to define edges in the X-direction of an area on the patterning device MA which is illuminated by EUV radiation.

Part of the conduit in the fluid nozzle 100 is shown. The conduit includes a first portion 106a which extends along the elongate structure 156, and a second portion 106b which extends beneath and above the openings 108,110. The second conduit portion 106b is wider than the openings 108,100 (i.e. in the Y-direction). This advantageously helps to deliver air to the openings at a higher pressure than if the second conduit portion 106b had the same width as the openings 108, 110. The second conduit portion 106b also connects to the opening 120 at the end of the fluid nozzle 100.

A cleaning process may be performed when a lithographic exposure is not taking place. The cleaning process may comprise moving the masking blades 20c,d such that tips of the masking blades are adjacent to each other but not touching. The cleaning process may comprise directing a jet of fluid 126 out of the end opening 120. In this embodiment the fluid is the same fluid as delivered out of the upper and lower openings 108, 110, and may be air. The jet of air 126 passes between tips of the masking blades 20c,d and cleans contamination from tips of the masking blades.

The fluid supply 104 may provide air at a sufficient flow rate that the jets of air 116, 118 provide a shear stress of 50 Pa or more at the cleaning reticle MA and/or at the masking blades 20a,b. The fluid supply 104 may provide air at sufficient flow rate that the jets of air 116, 118 provide a shear stress of 100 Pa or more at the cleaning reticle MA and/or at the masking blades 20a,b. The air may be provided at a flow rate which is sufficiently high that contamination particles are removed from the cleaning reticle MA and the masking blades 20a,b. The air may be provided at a flow rate which is sufficiently high that contamination particles are removed from the masking blades 20c,d delivered from the opening 120 in the wall of the fluid nozzle 100.

The fluid nozzle 100 may be stationary. However, the support structure MT moves in the Y-direction, as noted above in connection with Figure 2. The support structure MT is moved in the Y-direction whilst air is being delivered from the upper openings 108. As a result, a band of air passes along the support structure MT and thereby removes contamination particles (or other contamination) from the support structure MT and the cleaning reticle MA.

As schematically depicted, the cleaning reticle MA does not extend fully to edges of the support structure MT. Instead, end portions 12 of the support structure MT may extend beyond ends of the cleaning reticle MA. The openings 108 may be positioned such that parts of the support structure MT which receive the cleaning reticle MA pass over the openings 108 during a scanning movement of the support structure MT. This advantageously ensures that air delivered from the openings 108 is incident upon all of the cleaning reticle MA.

In other embodiments, the openings 108 may be positioned such that at least part of the end portions 12 of the support structure MT receive air from the openings during a scanning movement of the support structure.

The left hand masking blade 20a is moveable in the Y-direction as indicated by arrow 32. Through this movement of the masking blade 20a, the downward jet of air 118 from the openings 110 on the lower surface of the fluid nozzle 100 travels over the surface of the left hand masking blade 20a and removes contamination from that masking blade.

Similarly, the right hand blade 20b is moveable in the Y-direction as indicated by arrow 32. Through this movement of the masking blade 20b, a downward jet of air (not depicted) from openings in the additional portion 115 of the fluid nozzle 100 may travel over the surface of the right hand masking blade 20b and remove contamination from that masking blade. The downward jet of air 118 from the openings 110 on the lower surface of the fluid nozzle 100 may also travel over the surface of the left hand masking blade 20a and remove contamination from that masking blade.

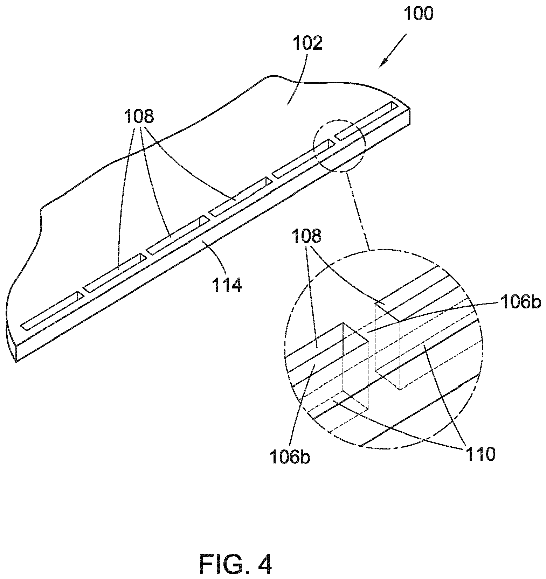

Figure 4 is a schematic perspective view of part of the distal end of the fluid nozzle 100, including an enlarged view of part of the distal end. Part of the series of openings 108 in the upper surface of the elongate structure 102 is shown. The series of openings 108 comprises a plurality of openings which are distributed along an upper surface of a distal end of the elongate structure 102. The openings are adjacent to the edge 114 of the fluid nozzle 100. The openings are elongate 108. The openings 108 may be generally rectangular, or may have some other shape.

Part of the series of openings 110 on the lower surface of the elongate structure 102 are also depicted in the enlarged part of Figure 4. The series of openings 110 comprises a plurality of openings which are distributed along a lower surface of a distal end of the elongate structure 102. The openings are adjacent to the edge 114 of the fluid nozzle 100. The openings are elongate 110. The openings 110 may be generally rectangular, or may have some other shape.

The second conduit portion 106b, which provides air to the openings 108, 110 can be seen in the enlarged part of Figure 4. As depicted, the second conduit portion 106b extends between the openings 108, 110 and connects to the openings.

Figure 5 is a schematic cross-sectional view from above of the fluid nozzle 100. Figure 5 shows both the main body portion 113 and the additional portion 115. Openings 150 are provided in a lower surface of the additional portion 115. Properties of these openings 150 may correspond with properties of the openings 110 provided in the main body portion 113. Openings 160 (not visible in Figure 5 but depicted in Figure 2) are also provided in an upper surface of the additional portion 115. Properties of these openings 160 may correspond with properties of the openings 108 provided in the main body portion 113.

As described further above in connection with Figures 3A and 3B, the conduit 106 comprises the first conduit portion 106a which extends within the elongate structure 102 from the fluid supply 104. As also described further above in connection with Figures 3A and 3B, the conduit 106 comprises the second conduit portion 106b which extends above the openings 110 provided in the main body portion 113 (and below openings 108 which are not visible in Figure 5). The conduit 106 further comprises a pair of third conduit portions 106c which extend to sides 151 of the elongate structure 102.

Sides 151 of the elongate structure 102 may have a vertical (Z-direction) dimension which is greater than an interior part of the elongate structure 102 (i.e. the part within which the first and second conduit portions 106a, 106b are provided). In other words, the sides 151 may be thicker than an interior part of the elongate structure 102. The sides 151 may for example have a rectangular cross-section. A pair of fourth conduit portions 106d extend along and within sides 151 of the elongate structure 102. The fourth conduit portions 106d extend to, and connect with, the additional portion 115 of the nozzle 100.

A fifth conduit portion 106e connects the fourth conduit portions 106d. The fifth conduit portion 106b extends above the openings 150 in the additional portion 115 of the nozzle, and below openings (not depicted) in an upper surface of the additional portion 115. The fifth conduit portion 106e is wider than the openings 150 (i.e. in the Y-direction). This advantageously helps to deliver air to the openings at a higher pressure than if the fifth conduit portion 106e had the same width as the openings 150.

In an embodiment, not depicted, the fluid nozzle 100 may comprise a main body portion 113 without the additional body portion 115.

In general, because the openings 108, 110 in the main body portion 113 are closer to the fluid supply 104 than the openings 150 in the additional body portion 115, air may be provided from the openings in the main body portion with a higher flow rate than air provided from the openings in the additional body portion. For this reason, if an additional body portion is present and includes openings 150 which provide a jet of air, a cleaning operation may primarily use the openings 108, 110 of the main body portion (i.e. more contamination may be removed by the openings of the main body portion than the openings of the additional body portion).

The fluid nozzle 100 may be provided with one or more series of openings.

Although the conduit 106 depicted in Figure 5 has a particular configuration, other configurations of conduit may be used. In general, the conduit may be configured to provide air to openings which can be used to provide jets of air.

In an embodiment, instead of having a series of openings 108 on the upper surface of the fluid nozzle 100, a single elongate opening may be provided. The length of the single elongate opening may be equal to or greater than the width of a standard patterning device (e.g. 152 mm (6 inches)). Similarly, instead of having a series of openings 110 on the lower surface of the fluid nozzle 100, a single elongate opening may be provided. The length of this single elongate opening may be equal to or greater than the width of a standard patterning device (e.g. 152 mm (6 inches)).

In embodiments in which series of openings 108, 110, 150, 160 are provided, the openings may extend over a distance which is equal to or greater than the width of a standard patterning device (e.g. 152 mm (6 inches)).

In an embodiment, the openings 108, 160 on the upper surface of the fluid nozzle 100 may be circular, oval or some other shape. In an embodiment, the openings 110, 150 on the lower surface of the fluid nozzle 100 may be circular, oval or some other shape.

Separation between neighbouring openings 108, 110 of a series of openings may for example be 2 mm or less, e.g. 1 mm or less.

The openings 108 on the upper surface of the main body 113 of the fluid nozzle 100 may be located 2 mm or less from the edge 114, e.g. 1 mm or less. The openings 110 on the lower surface of the main body 113 of the fluid nozzle 100 may be located 2 mm or less from the edge 114, e.g. 1 mm or less.

The openings 150 on the lower surface of the additional body 115 may be located adjacent to an edge 154 of the additional body. The openings 160 (see Figure 2) on the upper surface of the additional body 115 may be located adjacent to the edge 154 of the additional body. The openings 150 on the lower surface of the additional body 115 of the fluid nozzle 100 may be located 2 mm or less from the edge 154, e.g. 1 mm or less. The openings (not depicted) on the upper surface of the additional body 113 of the fluid nozzle 100 may be located 2mm or less from the edge 154, e.g. 1 mm or less.

The openings 108, 110, 150, 160 may for example measure up to 4mm across (in the Y-direction). The openings 108, 110, 150, 160 may for example measure at least 0.5mm across (in the Y-direction).

In an embodiment, the downward jet of air 118 has a lower flow rate than the upward jet of air 116. This may be advantageous because the downward jet of air 118 may be incident upon an encoder or other position measurement device, and could have a thermal impact upon the accuracy of the position measurement device. In other embodiments, the downward jet of air 118 may have substantially the same flow rate as the upward jet of air 116. The lower flow rate may be achieved by making the area of the lower openings 110, 150 smaller than the area of the upper openings 108.

In an embodiment, the openings 108 on the top of the fluid nozzle 100 may be omitted. Where this is the case, a jet of air cleans the masking blades 20, but there is not a corresponding jet of air cleaning the cleaning reticle MA. Other cleaning methods may be used for the cleaning reticle MA.

In an embodiment, the openings 110 on the lower surface of the fluid nozzle 100 may be omitted. Where this is the case, a jet of air cleans the cleaning reticle MA (and support structure MT) but there is not a corresponding jet of air cleaning the masking blades 20.

Cartesian coordinates are used in this description for ease of description. However, parts of embodiments of the invention may have a different orientation to the described Cartesian coordinates.

The above description refers to a jet of air (or other fluid). A jet of fluid may be considered to be fluid which is flowing from an opening and which has higher momentum than fluid which surrounds it. The term "jet" should not be interpreted as meaning that there is no divergence of the fluid after it leaves the openings.

In general, a flow of fluid (e.g. air) may be provided from the openings 108 in the upper surface of the main body portion 113. Fluid (e.g. air) may be provided from the openings 108 with a flow rate such that the fluid provides a shear stress of 50 Pa or more (e.g. 100 Pa or more) at the cleaning reticle MA. The fluid may be provided at a pressure which is sufficiently high that contamination particles are removed from the cleaning reticle MA.

A flow of fluid (e.g. air) may be provided from the openings in the upper surface of the additional body portion, e.g. with a flow rate such that the fluid provides a shear stress of 50 Pa or more (e.g. 100 Pa or more) at the cleaning reticle MA. The fluid may be provided at a pressure which is sufficiently high that contamination particles are removed from the cleaning reticle MA.

A flow of fluid (e.g. air) may be provided from the openings 110 in the lower surface of the main body portion 113, e.g. with a flow rate such that the fluid provides a shear stress of 50 Pa or more (e.g. 100 Pa or more) at the masking blade 20a. The fluid may be provided at a pressure which is sufficiently high that contamination particles are removed from the masking blade.

A flow of fluid (e.g. air) may be provided from the openings 150 in the lower surface of the additional body portion 115, e.g. with a flow rate such that the fluid provides a shear stress of 50 Pa or more (e.g. 100 Pa or more) at the masking blade 20b. The fluid may be provided at a pressure which is sufficiently high that contamination particles are removed from the masking blade 20b.

A flow of fluid (e.g. air) may be provided from the openings 160 in the upper surface of the additional body portion 115, e.g. with a flow rate such that the fluid provides a shear stress of 50 Pa or more (e.g. 100 Pa or more) at the cleaning reticle MA. The fluid may be provided at a pressure which is sufficiently high that contamination particles are removed from the cleaning reticle MA.

Fluid (e.g. air) may be provided from the opening 120 in the edge 114 of the main body portion 115 as a jet. The fluid may be provided with a flow rate such that the fluid provides a shear stress of 50 Pa or more (e.g. 100 Pa or more) at the masking blades 20c,d. The fluid may be provided at a pressure which is sufficiently high that contamination particles are removed from the masking blades 20c,d.

In above described embodiments, openings 110 in the lower surface of the main body portion 113 of the nozzle 100 are aligned in the scanning direction (Y-direction) with openings 108 in the upper surface of the main body portion of the nozzle. Similarly openings 150 in the lower surface of the additional body portion 115 of the nozzle 100 are aligned in the scanning direction (Y-direction) with openings (not visible) in the upper surface of the additional body portion of the nozzle. However, in other embodiments, openings in the upper and lower surfaces of the nozzle may be offset from each other.

The nozzle 100 may include one or more valves configured to selectively control which openings or series of openings receive fluid.

The series of openings 108, 160 provided on the upper surface of the fluid nozzle 100 may be referred to as upper openings. The series of openings 110, 150 provided on the lower surface of the fluid nozzle 100 may be referred to as lower openings.

In above described embodiments, a cleaning reticle MA is present when the cleaning operation is performed. However, the cleaning reticle MA may be absent when the cleaning operation is performed.

A method according to an embodiment of the invention may be performed by a computing device. The device may comprise a central processing unit ("CPU") to which is connected a memory. The method described herein may be implemented in code (software) stored on a memory comprising one or more storage media, and arranged for execution on a processor comprising on or more processing units. The storage media may be integrated into and/or separate from the CPU. The code, which may be referred to as instructions, is configured to be fetched from the memory and executed on the processor to perform operations in line with embodiments discussed herein. Alternatively it is not excluded that some or all of the functionality of the CPU is implemented in dedicated hardware circuitry, or configurable hardware circuitry like an FPGA.

The computing device may comprise an input configured to enable a user to input data into a software program running on the CPU. The input device may comprise a mouse, keyboard, touchscreen, microphone etc. The computing device may further comprises an output device configured to output results of measurements to a user.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A fluid nozzle for a patterning device environment of a lithographic apparatus comprising:
an elongate structure having an upper surface and a lower surface;
at least one lower opening provided in the lower surface of the elongate structure, and a conduit connected to the at least one lower opening, the at least one lower opening being configured to provide a flow of fluid delivered via the conduit.

2. The fluid nozzle of claim 1, wherein the fluid nozzle further comprises at least one upper opening provided in the upper surface of the elongate structure, the conduit being connected to the at least one upper opening, the at least one upper opening being configured to provide a flow of fluid delivered via the conduit.

3. The fluid nozzle of claim 2, wherein the at least one lower opening and/or the at least one upper opening is configured to provide a jet of fluid.

4. The fluid nozzle of claim 2 or claim 3, wherein the at least one lower opening and/or the at least one upper opening comprises a series of openings which extend across the elongate structure.

5. The fluid nozzle of any of claims 2 to 4, wherein the at least one lower opening and/or the at least one upper opening are provided adjacent to an edge which forms part of the elongate structure.

6. The fluid nozzle of any of claims 2 to 5, wherein a portion of the conduit extends above the at least one lower opening, and wherein the conduit portion is wider than the at least one lower opening.

7. The fluid nozzle of any of claims 2 to 6, wherein an area of the lower openings is smaller than an area of the upper openings.

8. The fluid nozzle of any of claims 2 to 7, wherein the at least one upper opening and/or the at least one lower opening has a width of up to 4mm.

9. The fluid nozzle of any of claims 2 to 8, wherein the at least one lower opening is oriented at an angle of between 20° and 70° relative to a plane which is perpendicular to the elongate structure.

10. The fluid nozzle of any of claims 2 to 9, wherein the at least one upper opening is oriented at an angle of between 20° and 70° relative to a plane which is perpendicular to the elongate structure.

11. The fluid nozzle of any preceding claim, wherein the fluid nozzle further comprises an opening provided in an end wall of the elongate structure.

12. The fluid nozzle of any preceding claim, wherein the elongate structure comprises a main body portion and an additional portion, and wherein the at least one lower opening is provided in the lower surface of the main body portion and/or the additional portion.

13. A fluid nozzle for a patterning device environment of a lithographic apparatus comprising:
an elongate structure having an upper surface and a lower surface;
at least one upper opening provided in the upper surface of the elongate structure, and a conduit connected to the at least one upper opening, the at least one upper opening being configured to provide a flow of fluid delivered via the conduit.

14. A lithographic patterning device environment comprising a fluid nozzle according to any preceding claim, wherein the at least one lower opening provided in the lower surface of the elongate structure is located above a masking blade.

15. A lithographic apparatus comprising the lithographic patterning device environment of claim 14, and further comprising a fluid supply configured to supply fluid to the at least one lower opening at a flow rate which provides a shear stress of 50 Pa or more at the masking blade.

16. The lithographic patterning device environment of claim 15, wherein the fluid supply is configured to supply air.

17. A method of cleaning a patterning device environment of a lithographic apparatus, the method comprising providing fluid to a fluid nozzle elongate structure, and directing the fluid out of at least one lower opening provided in a lower surface of the elongate structure, such that the fluid is incident upon a masking blade of the patterning device environment at a flow rate which is sufficiently high that contamination particles are removed from the masking blades.

18. A method of cleaning a patterning device environment of a lithographic apparatus, the method comprising providing fluid to a fluid nozzle elongate structure, and directing the fluid out of at least one upper opening provided in an upper surface of the elongate structure, such that the fluid is incident upon a cleaning reticle or support structure in the patterning device environment at a flow rate which is sufficiently high that contamination particles are removed from the cleaning reticle or the support structure.

19. The method of claim 17 or claim 18, wherein the fluid is directed at an angle of between 20° and 70° relative to a vertical plane.

20. The method of any of claims 17 to 19, wherein the fluid is air.
